# EUROPEAN PATENT APPLICATION

(11) **EP 1 394 610 A2**
(43) Date of publication of application: **03.03.2004**
(21) Application number: 03019913.7
(22) Date of filing: 02.09.2003
(51) Int. Cl.: G03F 1/14, G03F 7/20, G03F 1/00

(54) **Microlithography reticles including high-contrast reticle-identification codes, and apparatus and methods for identifying reticles based on such codes**

(30) Priority: 02.09.2002 JP 2002256347
(71) Applicant: Nikon Corporation, Tokyo 140-8601 (JP)
(72) Inventor: Udagawa, Jin, Tokyo 100-8331 (JP); Okino, Teruaki, Tokyo 100-8331 (JP); Hirayanagi, Noriyuki, Tokyo 100-8331 (JP)
(74) Representative: Viering, Jentschura & Partner

(57) **Abstract**

Microlithography reticles are disclosed that include a high-contrast reticle-identification code (bar code). The bar code is configured as a pattern (usually linearly arrayed) of high-scattering regions (bar-code elements) each exhibiting a relatively high degree of reflection-scattering of irradiated probe light. The high-scattering regions are separated from one another by respective low-scattering regions each exhibiting a relatively low degree of reflection-scattering of incident probe light. For example, the low-scattering regions have smooth surfaces from which very little probe light is reflection-scattered, wherein each high-scattering region includes multiple scattering features such as line, channels, projections, or the like that provide multiple edges and/or points that reflection-scatter probe light. The edges in a high-scattering region can be arranged with a line-space (L/S) pitch that is below the resolution limit of an optical system that delivers probe light to the bar code and detects probe light reflection-scattered from the bar code.

## Description

### Field

This disclosure pertains to microlithography, which is a key technique used in the manufacture of microelectronic devices (*e.g.*, semiconductor integrated circuits and displays) and micromachines, for example. More specifically, the disclosure pertains to microlithography of a pattern, defined by a mask (including the pattern master plate and reticle) and exposure method used therein. It particularly relates to a mask that has an identification code that is easy to read for identifying a plurality of different masks.

### Background

Recent years have witnessed a relentless drive to achieve progressively finer pattern resolution in microlithography. The impetus for this drive is the persistent demand, in the microelectronics-fabrication industry, for integrated circuits (*e.g*., microprocessor and memory chips) having increasingly denser arrays of active circuit elements (*e.g*., transistors or memory cells) and/or circuits having increasingly greater numbers of active circuit elements. Achieving these goals has exceeded the ability of optical microlithography (*i.e.*, lithography performed using deep-UV light) to provide adequate linewidth resolution, which has led to efforts to develop "next-generation lithography" (NGL) systems capable of achieving substantially finer resolution than obtainable with optical microlithography.

A key NGL technology utilizes a charged particle beam (notably an electron beam) as a lithographic energy beam. Electron-beam microlithography potentially achieves finer resolution than optical microlithography for reasons similar to reasons for which electron microscopy achieves finer imaging resolution than optical microscopy. Most optical microlithography systems project onto an exposure-sensitive substrate a pattern from a master plate called a "mask" or "reticle" (the term "reticle" is used herein). The earliest electron-beam microlithography systems were direct-writing apparatus similar to apparatus conventionally used for mask-writing. Rather than projecting a pattern from a reticle, these early apparatus "wrote" the pattern line-by-line using a fine electron beam. Consequently, they exhibited extremely low throughput (number of production units, such as exposed wafers, that can be processed per unit time). Later electron-beam microlithography systems achieved better throughput by exposing small groups ("cells") of pattern elements (especially of highly repeated pattern units such as in memory chips) simultaneously in respective shots. Nevertheless, whereas in optical microlithography an entire LSI pattern can be exposed in a single exposure "shot," it currently is impossible to projection-expose an entire LSI pattern in a single shot using electron-beam microlithography. Despite this disadvantage, more recent electron-beam microlithography systems have been developed that exhibit throughput sufficient for use in mass-production wafer-fabrication facilities. These more recent systems utilize a "divided" reticle that defines the pattern, to be exposed, as an array of subfields that are individually exposed in a sequential manner. Each subfield defines a respective portion of the overall pattern and is substantially larger than a "cell" exposed by earlier electron-beam systems. The subfield images are projected onto the substrate in a manner by which the images are formed contiguously with each other. Projection normally is performed with demagnification ("reduction"), which means that the images formed on the substrate are smaller than the corresponding pattern on the reticle.

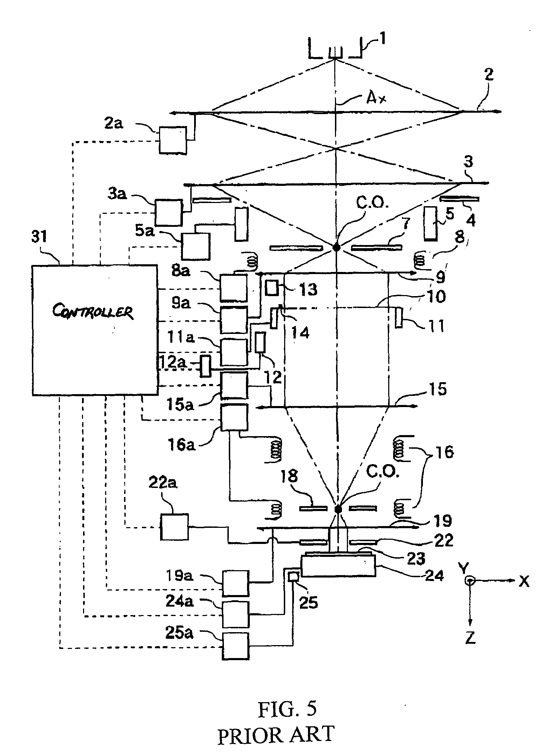

An exemplary divided-reticle, electron-beam microlithography system useful for mass-production of exposed wafers is shown in FIG. 5, which depicts an overview of imaging and control relationships of the system.

Situated at the extreme upstream end of the system is an electron gun 1 that emits an electron beam propagating in a downstream direction generally along an optical axis Ax. Downstream of the electron gun 1 are a first condenser lens 2 and a second condenser lens 3 collectively constituting a two-stage condenser-lens assembly. The condenser lenses 2, 3 converge the electron beam at a crossover C.O. situated on the optical axis Ax at a blanking diaphragm 7.

Downstream of the second condenser lens 3 and situated at the crossover C.O. is a "beam-shaping diaphragm" 4 comprising a plate defining an axial aperture (typically square or rectangular in profile) that trims and shapes the electron beam passing through the aperture. Thus, the beam is appropriately sized for illumination of only one subfield on the reticle 10 at a time. An image of the beam-shaping diaphragm 4 is formed on the reticle 10 by an illumination lens 9.

The electron-optical components situated between the electron gun 1 and the reticle 10 collectively constitute an "illumination-optical system" of the depicted microlithography system. The electron beam propagating through the illumination-optical system is termed an "illumination beam" because it illuminates a desired region of the reticle 10. As the illumination beam propagates through the illumination-optical system, the beam actually travels in a downstream direction through an axially aligned "beam tube" (not shown but well understood in the art) that can be evacuated to a desired vacuum level.

A blanking deflector 5 is situated downstream of the beam-shaping aperture 4. The blanking deflector 5 laterally deflects the illumination beam as required to cause the illumination beam to strike the aperture plate of the blanking diaphragm 7, thereby preventing the illumination beam from being incident on the reticle 10 during times in which exposure is not being performed.

A subfield-selection deflector 8 is situated downstream of the blanking diaphragm 7. The subfield-selection deflector 8 laterally deflects the illumination beam as required to illuminate a desired subfield situated on the reticle 10 within the optical field of the illumination-optical system. Thus, subfields of the reticle 10 are scanned sequentially by the illumination beam in a horizontal direction (X-direction in the figure). The illumination lens 9 is situated downstream of the subfield-selection deflector 8.

The reticle 10 typically defines a large number (*e.g.*, thousands) of subfields. The subfields collectively define the pattern for a layer to be formed at a single die ("chip") on a lithographic substrate. The reticle 10 is mounted on a movable reticle stage 11. The reticle stage 11 moves the reticle 10 in a direction (X- and Y-directions and combinations thereof) that is perpendicular to the optical axis Ax, thereby allowing respective subfields on the reticle 10, extending over a range that is wider than the optical field of the illumination-optical system, to be illuminated. The position of the reticle stage 11 in the XY plane is determined using a "position detector" 12 that typically is configured as a laser interferometer. The laser interferometer is capable of measuring the position of the reticle stage 11 with extremely high accuracy in real time.

In general, fabricating a microlithographic device on a substrate involves forming many superposed layers each involving at least one lithographic transfer of a respective pattern from a reticle. To make sure that the proper reticle is being used for a particular exposure step, each reticle bears a unique identification code 14, which is "read" using an optical system 13 (discussed later below). During a day's production use of the microlithography system, the respective identification codes 14 on multiple reticles used by the system are read by the optical system 13 to ensure that the proper reticle is being used.

Situated downstream of the reticle 10 are first and second projection lenses 15, 19, respectively, and an imaging-position deflector 16. The illumination beam, by passing through an illuminated subfield of the reticle 10, becomes a "patterned beam" because the beam downstream of the reticle carries an aerial image of the illuminated subfield. The patterned beam is imaged at a specified location on a substrate 23 (*e.g.*, "wafer") by the projection lenses 15, 19. To ensure imaging at the proper location on the substrate surface, the imaging-position deflector 16 imparts the required lateral deflection of the patterned beam.

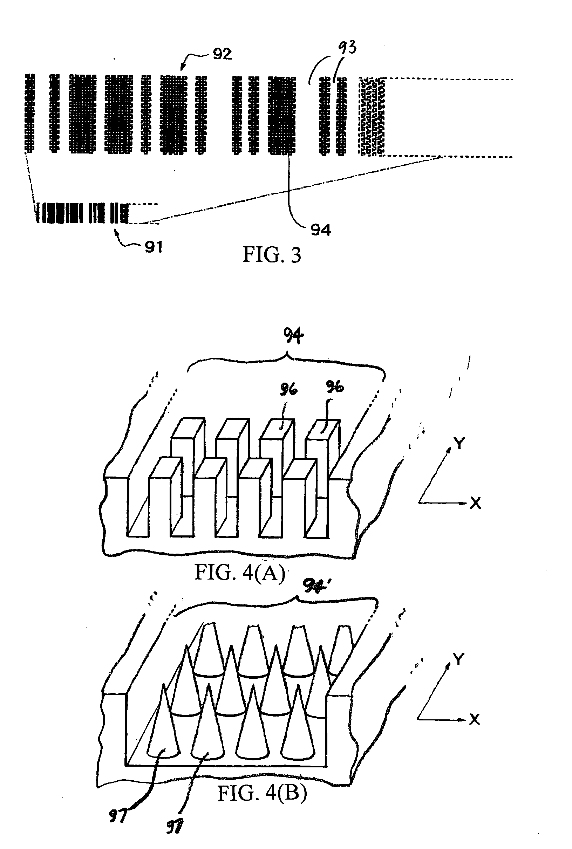

So as to be imprintable with the image carried by the patterned beam, the upstream-facing surface of the substrate 23 is coated with a suitable "resist" that is imprintably sensitive to exposure by the patterned beam. When forming the image on the substrate, the projection lenses collectively "reduce" (demagnify) the aerial image. Thus, the image as formed on the substrate 23 is smaller (usually by a defined integer-ratio factor termed the "demagnification factor") than the corresponding region illuminated on the reticle 10. By thus causing imprintation of the surface of the substrate 23, the system of FIG. 4 achieves "transfer" of the pattern image from the reticle 10 to the substrate 23.

The components of the depicted electron-optical system situated between the reticle 10 and the substrate 23 collectively are termed the "projection-optical system." The substrate 23 is mounted to a substrate stage 24 situated downstream of the projection-optical system. As the patterned beam propagates through the projection-optical system, the beam actually travels in a downstream direction through an axially aligned "beam tube" (not shown but well understood in the art) that can be evacuated to a desired vacuum level.

The projection-optical system forms a crossover C.O. of the patterned beam on the optical axis Ax at the back focal plane of the first projection lens 15. The position of the crossover C.O. on the optical axis Ax is a point at which the axial distance between the reticle 10 and substrate 23 is divided according to the demagnification ratio. Situated between the crossover C.O. (*i*.*e*., the rear focal plane) and the reticle 10 is a contrast-aperture diaphragm 18. The contrast-aperture diaphragm 18 comprises an aperture plate that defines an aperture centered on the axis Ax. With the contrast-aperture diaphragm 18, electrons of the patterned beam that were scattered during transmission through the reticle 10 are blocked so as not to reach the substrate 23.

A backscattered-electron (BSE) detector 22 is situated immediately upstream of the substrate 23. The BSE detector 22 is configured to detect and quantify electrons backscattered from certain marks situated on the upstream-facing surface of the substrate 23 or on an upstream-facing surface of the substrate stage 24. For example, a mark on the substrate 23 can be scanned by a beam that has passed through a corresponding mark pattern on the reticle 10. By detecting backscattered electrons from the mark at the substrate 23, it is possible to determine the relative positional relationship of the reticle 10 and the substrate 23.

The substrate 23 is mounted to the substrate stage 24 via a wafer chuck (not shown but well understood in the art), which presents the upstream-facing surface of the substrate 23 in an XY plane. The substrate stage 24 (with chuck and substrate 23) is movable in the X- and Y-directions. Thus, by simultaneously scanning the reticle stage 11 and the substrate stage 24 in mutually opposite directions, it is possible to transfer each subfield within the optical field of the illumination-optical system as well as each subfield outside the optical field to corresponding regions on the substrate 23. The substrate stage 24 also includes a "position detector" 25 configured similarly to the position detector 12 of the reticle stage 11.

Each of the lenses 2, 3, 9, 15, 19 and deflectors 5, 8, 16 is controlled by a controller 31 via a respective coil-power controller 2a, 3a, 9a, 15a, 19a and 5a, 8a, 16a. Similarly, the controller 31, via respective stage drivers 11a and 24a, controls operation of the reticle stage 11 and substrate stage 24. The position detectors 12, 25 produce and route respective stage-position signals to the controller 31 via respective interfaces 12a, 25a each including amplifiers, analog-to-digital (A/D) converters, and other circuitry for achieving such ends. In addition, the BSE detector 22 produces and routes signals to the controller 31 via a respective interface 22a.

From the respective data routed to it, the controller 31 ascertains, *inter alia*, errors of the respective stage positions as a subfield is being transferred. To correct such errors, the imaging-position deflector 16 is energized appropriately to deflect the patterned beam. Thus, a reduced image of the illuminated subfield on the reticle 10 is transferred accurately to the desired target position on the substrate 23. This real-time correction is made as each respective image of a subfield is transferred to the substrate 23, and the images are positioned such that they are stitched together in a proper manner on the substrate 23.

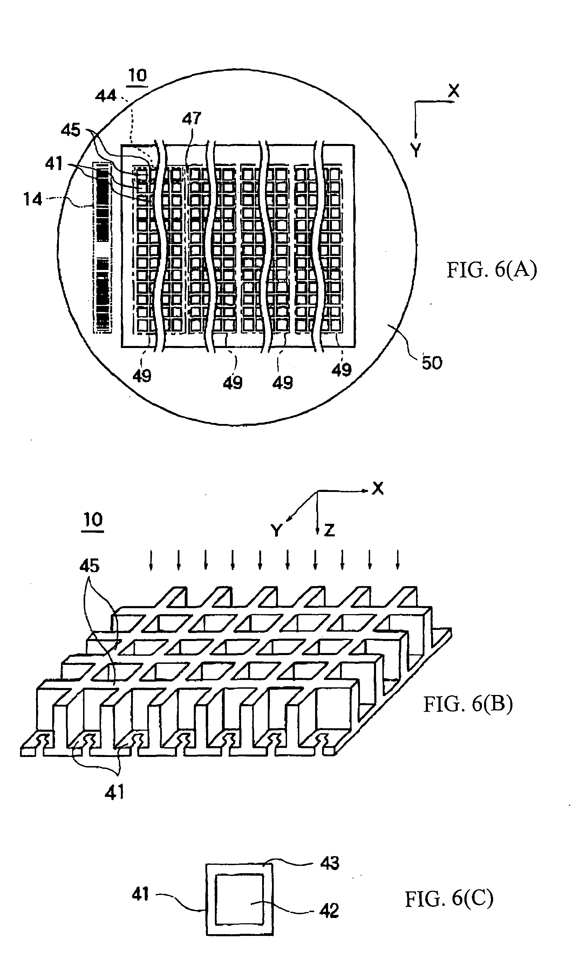

A reticle as used in an electron-beam microlithography system, such as the system shown in FIG. 5, is depicted in FIGS. 6(A)-6(C). FIG. 6(A) is an overall plan view, FIG. 6(B) is a perspective view of a portion of the reticle, showing multiple small membrane regions (each including a respective subfield), and FIG. 6(C) is a plan view of a single small membrane region. As shown in FIG. 6(A), the reticle is divided into a large number of small membrane regions 41 each typically including a respective subfield. The small membrane regions 41 are arranged in several groups, termed "mechanical stripes" 49, each containing multiple rows ("electrical stripes") 44 of small membrane regions 41. Four mechanical stripes 49 are shown, and each row 44 contains multiple small membrane regions 41. Each small membrane region 41 has a thickness that typically is in the range of 1 to 2 µm, for example, for a "stencil"-type reticle. As shown in FIG. 6(C), each small membrane region 41 includes a central patterned portion that is the actual respective subfield 42 and a peripheral region ("skirt") 43 that surrounds the subfield 42 in the manner of a picture frame. The subfield 42 defines a respective portion of the pattern defined by the reticle 10. The skirt 43 is not patterned, and is a zone in which fall the edges of the illumination beam illuminating the respective small membrane region 41 during exposure.

The reticle 10 can be a "stencil"-type reticle, in which pattern elements are defined by respective beam-transmissive (non-scattering) openings in the relatively beam-scattering membrane. Alternatively, the reticle 10 can be a "scattering-membrane" type, in which pattern elements are defined by respective units of a highly scattering layer formed on a relatively low-scattering membrane. In FIG. 6(B), the actual units of the scattering layer are formed on the under-surfaces of the small membrane region 41.

Note that the small membrane regions 41 are separated from each other in each mechanical stripe 49 by a latticed network of minor struts 45 called "grillage." The minor struts 45 intersect each other at right angles and, in the nature of structural beams, provide substantial rigidity to and mechanical support for the reticle 10. The thickness (in the Z-direction) of each minor strut 45 is 0.7 mm, for example, and the small membrane regions 41 extend from the "lower" portions of the minor struts 45 to cover the respective openings between the minor struts.

In FIG. 6(A), each row of small membrane regions 41 extends in the X-direction and forms a respective "electrical stripe" 44. Each mechanical stripe 49 comprises multiple electrical stripes 44 arrayed in the Y-direction. The length of each electrical stripe 44 (corresponding to the width of the respective mechanical stripe 49) is established by the width of the optical field of the illumination-optical system. The width of the optical field is limited by the maximum range (in the X-direction) of beam deflection that can be achieved by the subfield-selection deflector 8. The electrical stripes 44 are so named because beam deflection required to illuminate the small membrane regions 41 in each electrical stripe 44 is performed electrically by the subfield-selection deflector 8. The mechanical stripes 49 are so named because the constituent electrical stripes 44 are brought into position for exposure by mechanical movements of the reticle stage 11 and of the substrate stage 24.

In the reticle 10 shown in FIG. 6(A) multiple mechanical stripes 49 are arrayed in the X-direction. Between the mechanical stripes 49 are respective major struts 47 to which the minor struts 45 are contiguous. The major struts 47 typically have the same thickness (in the Z-direction) as the minor struts 45 but are substantially wider in the X-direction. The major struts 47 effectively prevent sagging and bending of the reticle 10. The outer periphery 50 of the reticle 10 typically is circular and has the same thickness (in the Z-direction) as the minor struts 45 and major struts 47.

The reticle 10 also includes a band-shaped identification code 14 that, in FIG. 6(A), extends in the Y-direction and is situated to the left of the array of mechanical stripes 49. The identification code 14 serves to uniquely identify the reticle, thereby facilitating control of the automated traffic of multiple reticles 10 into and out of the microlithography system. Typically, the identification code 14 is in the form of a bar code, which is the name used generally herein.

The bar code 14 is "read" by the optical system 13 (FIG. 5). To such end, the optical system 13 includes a light source (e.g., an infrared LED) that illuminates the bar code 14 with a beam of "probe light," and a reflected-light sensor (e.g., a CCD Sensor) that detects probe light reflecting from the bar code 14. Between the bar code 14 and the reflected-light sensor is a lens or the like for focusing probe light reflected from the bar code 14 an the surface of the sensor. The sensor is connected to a processor (e.g., the controller 31) that perfonns image-processing and image-discrimination of data produced by the sensor.

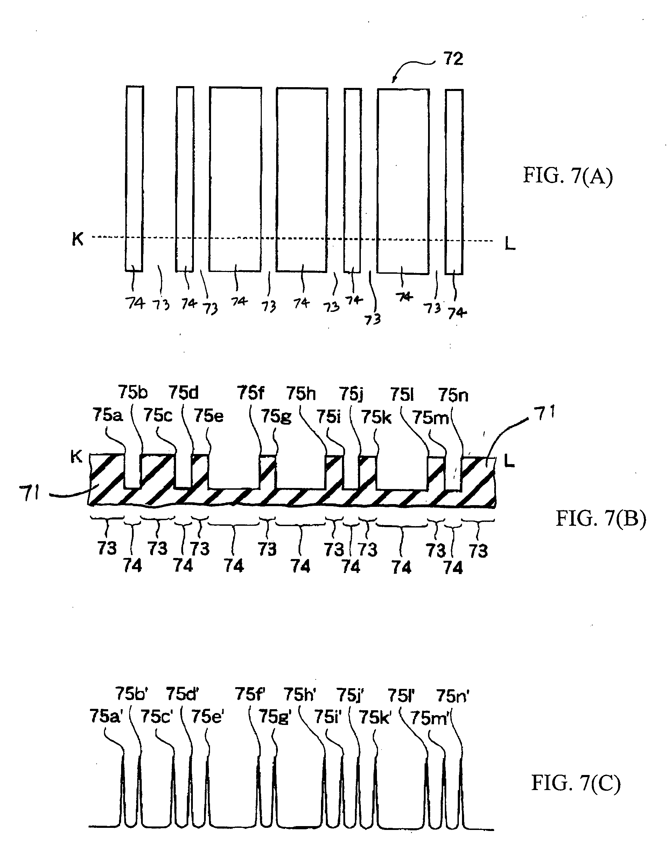

For electron-beam microlithography, the reticle 10 is fabricated from a "reticle substrate" that typically is silicon or diamond-like carbon (DLC). According to conventional practice, the elements of the bar code 14 are fonned an the reticle substrate either by lithography and vapor deposition or lithography and etching. In the 15vapor-deposition method, the elements of the bar code are fonned of respective zones of a material, deposited an the surface of the reticle substrate, exhibiting a reflectivity to incident probe light that is substantially greater than the reflectivity of the reticle substrate to probe light. In the etching method, the elements of the bar code are fonned as corresponding high- and low-elevation features defined in the reticle substrate (See FIG. 7(B), for example). The vapor-deposition method is not favored, largely for reasons of high cost.

Turning now to FIGS. 7(A)-7(C), certain details are shown of the conventional 25 etching method that results in bar-code elements being defined by local differences in reticle-Substrate thickness. FIG. 7(A) is a plan view of an exemplary bar code 72; FIG. 7(B) is an elevational section along the live K-L of the bar code of FIG. 7(A); and FIG. 7(C) is an exemplary detection signal produced by probe light that is reflection-scattered from the bar code. Referring to FIGS. 7(A) and 7(B), the bar code 72 is configured as an arrangement of multiple bar-code elements 74 separated from each other by intervening regions 73. The intervening regions 73 extend upward to the surface plane of the reticle substrate 71 and thus have planar tops. The bar-code elements 74 are configured as respective voids defined in the reticle substrate 71. As probe light is irradiated on the bar code 72, the probe light is reflection-scattered only at the edges 75a, 75b, ..., 75n of the bar-code elements 74 (FIG. 7(B)). This reflection-scattered probe light is detected using the optical system 13 (FIG. 5), which produces the detection signal shown in FIG. 7(C). The peaks 75a', 75b', ...., 75n' of the detection signal correspond to the edges 75a, 75b, ..., 75n of the bar-code elements 74 (FIG. 7(B)). In other words, only the edges 75a, 75b, ..., 75n produce signal. As a result, wide bar-code elements 74 produce no more signal than narrow bar-code elements 74. For example, the edges 75e and 75f of a relatively wide bar-code element 74 produce no more signal than the edges 75d and 75e of a relatively narrow bar-code element 74. Also, since the edges 75a, 75b, ..., 75n also effectively are edges of the intervening regions 73, the bar-code elements 74 produce no more signal than the intervening regions 73. The resulting lack of signal distinction can result in the signal contrast being insufficient for accurate reading of the bar code 72. In such instances the bar code 72 easily can be misread, which hinders achievement of a desired level of control of reticle traffic to and from the reticle stage 11.

### Summary

In view of the shortcomings of conventional technology as summarized above, provided hereby are reticles that include respective identification codes having sufficient contrast to ensure error-free reticle identification and control of reticle traffic to and from the microlithography system.

To such end and according to a first aspect of the invention, reticles are provided for use in microlithography of a device pattern to an exposure-sensitive substrate using an energy beam. An embodiment of such a reticle comprises a reticle substrate on which is defined a device pattern to be transfer-exposed onto the exposure-sensitive substrate. A reticle-identification code is defined on the surface of the reticle substrate. The reticle-identification code comprises multiple high-scattering regions each exhibiting a relatively high degree of reflection-scattering of irradiated probe light. The high-scattering regions are separated from one another by respective low-scattering regions exhibiting a low degree of reflection-scattering of the irradiated probe light, relative to the high-scattering regions.

Reflection of probe light from the high-scattering regions, relative to the low-scattering regions, provides a higher-contrast code-detection signal than obtainable using a conventional reticle-identification code. The higher-contrast signal provides more error-free identification of each code, and more trouble-free movement of reticles to and from the microlithography apparatus and/or in any of various other reticle-movement or storage processes.

The low-scattering regions desirably present respective surfaces that are sufficiently smooth to avoid significant reflection-scattering, from the surfaces, of probe light incident on the surfaces. In contrast, the high-scattering regions comprise multiple scattering features that reflection-scatter incident probe light. The surfaces of the low-scattering regions, on which probe light is incident, can be coplanar with the surface of the reticle substrate. The scattering features in each of the high-scattering regions can comprise multiple points such as defined by respective pyramidal or conical projections. Alternatively, the scattering features can comprise multiple edges. For example, the edges in each high-scattering region can be configured to flank at least one channel extending in the high-scattering region and subdividing the respective high-scattering region. By way of another example, each high-scattering region can have multiple respective channels that subdivide the high-scattering region, wherein the multiple channels extend parallel to each other and/or perpendicularly to each other.

In general, in view of the presence of two edges per bar-code element in a conventional reticle-identification code, each high-scattering region in a reticle as claimed herein defines three or more edges that reflection-scatter incident probe light. These edges can extend parallel to each other and/or perpendicularly to each other. The multiple edges in each high-scattering region can be defined by multiple respective channels extending in each high-scattering region, wherein the channels can extend parallel to each other and/or perpendicularly to each other.

Further by way of example, the features in each high-scattering region of the reticle-identification code can comprise a line-and-space pattern defining multiple edges. The line-and-space pattern can have a pitch that is below the resolution limit of an optical system used for reading probe light reflected from the identification code.

Even further by way of example, the features in each high-scattering region comprise a checkerboard pattern of projections and recesses that collectively define multiple edges. The checkerboard pattern can have a pitch that is below the resolution limit of an optical system used for reading probe light reflected from the identification code.

By having the pitch be below the resolution limit of the optical system, the optical system is not able to read the respective borderlines of the bar-code elements. Rather, only the reflection-scattering features inside the bar-code elements are readable, which provides better assurance against mis-reading of the bar code.

According to another aspect of the invention, microlithographic-exposure apparatus are provided. An embodiment of such an apparatus comprises an illumination-optical system situated and configured to illuminate a reticle with a lithographic energy beam. The reticle comprises: (a) a reticle substrate having a surface on which is defined a device pattern to be transfer-exposed onto an exposure-sensitive substrate, and (b) a reticle-identification code defined on the surface of the reticle substrate. The identification code comprises multiple high-scattering regions each exhibiting a relatively high degree of reflection scattering of irradiated probe light. The high-scattering regions are separated from one another by respective low-scattering regions exhibiting a relatively low degree of reflection scattering of the irradiated probe light. The microlithographic-exposure apparatus also includes a probe-light optical system situated relative to the reticle and configured to direct a beam of probe light to the identification code on the reticle and to sense probe light reflected from the identification code so as to provide an identification of the reticle.

Yet another aspect of the invention is a method set forth in the context of a microlithographic method in which a pattern, defined on a reticle, is transfer-exposed from the reticle to an exposure-sensitive lithographic substrate. The subject method is for identifying a reticle, and comprises the step of providing on the reticle an identification code. The identification code is defined on a surface of the reticle and comprises multiple high-scattering regions each exhibiting a relatively high degree of reflection scattering of irradiated probe light. The high-scattering regions are separated from one another by respective low-scattering regions exhibiting a relatively low degree of reflection scattering of the irradiated probe light. In another step of the method a beam of probe light is irradiated on the identification code. Probe light reflected from the identification code is sensed. From the sensed probe light, a determination is made of the identity of the reticle corresponding to the identification code.

The foregoing and additional features and advantages of the invention will be more readily apparent from the following detailed description, which proceeds with reference to the accompanying drawings.

### Brief Description of the Drawings

FIG. 1 is a plan view of a reticle-identification code ("bar code") according to a first representative embodiment. Also shown is a bar-code image, such as would be projected onto a downstream substrate, of the bar code.
FIG. 2(A) is an elevational section (along the line M-N) of a portion of the bar code shown in FIG. 1.
FIG. 2(B) is an elevational section (along the line M-N) of a portion of a variation of the FIG.-2(A) embodiment having V-shaped channels rather than the u-shaped channels in the FIG.-2(A) configuration.
FIG. 2(C) is a plot of an exemplary detection signal produced by detecting probe light that has been reflection-scattered from the bar code shown in FIG. 2(A).
FIG. 3 is a plan view of a bar code according to a second representative embodiment. Also shown is a bar-code image, such as would be projected onto a downstream substrate, of the bar code.
FIG. 4(A) is an oblique view of a high-scattering bar-code element, of the bar code of FIG. 3, in which the bar-code element is made highly scattering by multiple channels that subdivide the bar-code element in the X- and Y-directions into multiple planar-topped projections providing a large number of edges that reflection-scatter incident probe light.
FIG. 4(B) is an oblique view of a variation of the bar-code element of FIG. 4(A), wherein, in FIG. 4(B) the bar-code element comprises multiple conical projections each having a respective point that reflection-scatters incident probe light.
FIG. 5 is an elevational schematic diagram showing overall imaging relationships and control systems in a conventional divided-reticle, electron-beam, projection-microlithography system.
FIG. 6(A) is a plan view of a conventional divided reticle including an identification code (bar code) used for reticle identification.
FIG. 6(B) is an oblique view of a portion of the reticle shown in FIG. 6(A), wherein FIG. 6(B) provides detail of the grillage.
FIG. 6(C) is a plan view of a single small membrane region of the reticle of FIG. 6(A), showing the respective subfield and skirt.
FIG. 7(A) is a plan view of a conventional reticle-identification code ("bar code").
FIG. 7(B) is an elevational section (along the line K-L) of a portion of the bar code shown in FIG. 7(A).
FIG. 7(C) is a plot of the detection signal produced by detecting probe light that has been reflection-scattered from the conventional bar code shown in FIG. 7(A).

### Detailed Description

The invention is described below in the context of representative embodiments that are not intended to be limiting in any way.

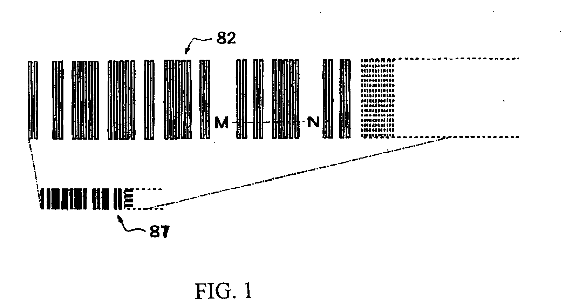

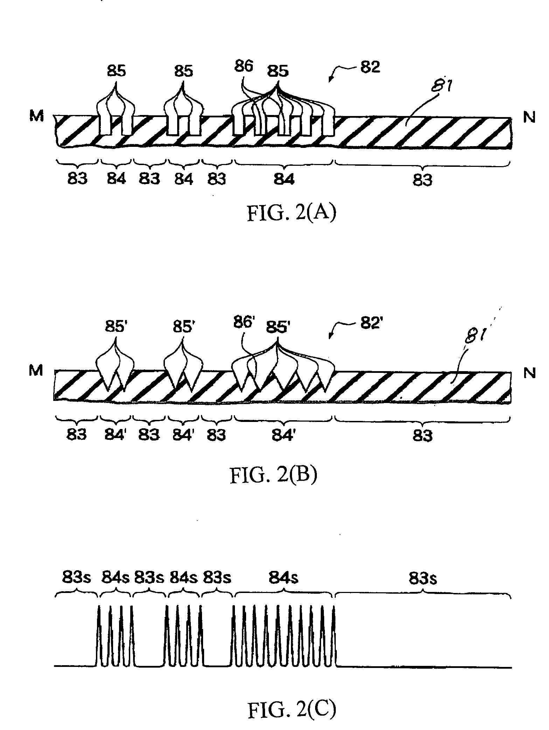

A first representative embodiment of a bar code 82, as formed on a reticle, is shown in FIG. 1 in plan view. An enlarged elevational section, along the line M-N in FIG. 1, of a portion of the bar code 82 is shown in FIG. 2(A). The bar code 82 is configured as an arrangement of multiple bar-code elements 84 separated from each other by intervening regions 83. The intervening regions 83 present respective "top" surfaces that are coplanar with each other and with the surface plane of the reticle substrate 81. Hence, the intervening regions 83 have planar "top" surfaces in a manner similar to the intervening regions 73 of the conventional bar code 72 shown in FIG. 7(A).

In contrast with the conventional bar code 72 of FIG. 7(A), each bar-code element 84 of the bar code 82 in FIG. 2(A) is subdivided to include multiple recessed portions ("channels") 86 extending depthwise into the reticle substrate 81. As a result, each bar-code element 84 presents more than two light-scattering edges 85, compared to the only two edges per bar-code element 74 of the conventional bar code 72. The "top" surfaces of the intervening regions 83 typically are sufficiently smooth to prevent significant scattering of incident probe light, and have no edges that would cause reflection-scattering of the incident probe-light beam. Each bar-code element 84, in contrast, is "crowded" with edges 85 (more than two edges per element) each exhibiting a high level of reflection-scattering of the incident probe-light beam. As a result, the bar-code elements 84 are "high-scattering" regions and the intervening regions 83 are "low-scattering" regions of the bar code 82. The bar-code elements 84 and intervening regions 83 are arrayed in a linear manner to form the bar code 82.

Referring further to FIG. 2(A), the edges 85 in each bar-code element 84 are defined by multiple channels 86 formed in the reticle substrate 81. These channels 86 can be formed by, *e.g.*, lithography followed by an etching step. In FIG. 2(A) the channels 86 are rectilinear and extend perpendicularly into the thickness dimension of the reticle substrate 81.

An alternative embodiment of a bar code 82' is shown in FIG. 2(B), in which the channels 86' in each bar-code element 84' are V-shaped. The embodiment of FIG. 2(B) does not have as many edges 85' per bar-code element 84' as the embodiment of FIG. 2(A), but both embodiments nevertheless present more than the conventional two edges per bar-code element. In other words, both embodiments have bar-code elements that are "crowded" with edges 85, 85' that perform reflection-scattering of incident probe light. Thus, each bar-code element 84, 84' is a respective high-scattering region, compared to the intervening regions 83, of the respective bar code 82, 82'.

An exemplary probe-light-detection signal produced by the bar code 82 of FIG. 2(A) is shown in FIG. 2(C). The signal comprises "null" portions 83s corresponding to the intervening regions 83 of the bar code 82. The signal also comprises "signal" portions 84s each corresponding to a respective bar-code element 84. It readily can be seen that each signal portion 84s includes a group of signal peaks (at least four peaks per element in this embodiment) crowded together. Each signal peak corresponds to and is produced by reflection-scattering of probe light from a respective edge 85. The production of many signal peaks by each bar-code element 84 (*i.e.*, by each high-scattering region of the bar code) produces correspondingly enhanced "brightness" of the signal portions compared to the signal produced by a conventional bar code. Consequently, the bar code 82 produces a substantially higher-contrast signal than a conventional bar code and is more easily detected without errors than a conventional bar code.

The bar-code embodiment 82' of FIG. 2(B) also produces a signal having more than two peaks per bar-code element. For example, the left-most element 84' has three edges 85' and hence produces three peaks, and the right-most element 84' has six edges and hence produces six peaks. As a result, the respective signal portions produced by the bar-code elements 84' have enhanced brightness, and the bar code 82' produces a higher-contrast signal, compared to the signal produced by a conventional bar code.

In the conventional bar code 72 shown in FIG. 7(A), the bar-code elements 74 are not highly scattering compared to the intervening regions 73. As a result, the bar-code elements 74 do not produce as "bright" a signal as bar-code elements 84 of the embodiments of FIGS. 2(A) and 2(B). By configuring each bar-code element 84 with more than two edges, as in the embodiments of FIGS. 2(A) and 2(B), higher-contrast bar-code-detection signals are produced. These higher-contrast signals, in turn, allow the bar codes to be detected by the optical system 13 more accurately more often, yielding smoother and more trouble-free control of reticle traffic to and from the microlithography system.

Providing the bar code 82 with high-scattering regions 84 and low-scattering regions 83 as described above also provides a high-contrast bar-code image 87 (FIG. 1) as projected from the reticle 10 to the substrate 23. This bar-code image 87 is suitable for detection purposes.

In the bar codes of FIGS. 1 and 2(A)-2(B), each bar-code element (*i*.*e*., each high-scattering region) 84 can be configured, for example, in the manner described above, such that the channels 86 are sized and spaced apart from one another at line-and-space (L/S) intervals above the resolution limit of the optical system 13 reading probe light reflected from the bar code 82. Alternatively, the L/S interval can be below the resolution limit of the optical system 13. For example, in this alternative configuration the array of edges 85 has a pitch that is below the resolution limit of the optical system 13. With such a fine pitch, the respective outer edge of each high-scattering element 84 is not detected, resulting in greater resolution of the bar-code elements as read by the optical system 13. Nevertheless, the signal from the high-scattering regions 84 has enhanced brightness compared to the signal from a conventional bar code.
Yet another representative embodiment of a bar code 92 is depicted in FIG. 3, in which the high-scattering regions (bar-code elements) 94 present a large number of edges that are two-dimensionally arrayed (in the X- and Y-directions) in the manner of a checkered pattern. Desirably, the pitch of edges in each of the X- and Y-directions is below the resolution limit of the optical system 13 reading reflected probe light. The respective pitch in the X- and Y-directions need not be identical. Detail of a portion of a high-scattering region 94 is shown in FIG. 4(A), in which each Bar code element is configured as an X-Y matrix of small square pillars 96. An alternative embodiment is shown in FIG. 4(B), in which each bar-code element 94'is configured as an X-Y matrix of cones 97 or pyramids. Both configurations present a respective crowded array of a very large number of edges (of the pillars 96) or points (of the apices of the cones 97) that reflection-scatter incident probe light.

The high-scattering bar-code elements 94 in the embodiment of FIG. 3 are very "bright" compared to the intervening regions 93. In fact, the high-scattering bar-code elements 94 are brighter than the high-scattering bar-code elements 84, 84' of the embodiments of FIGS. 2(A) and 2(B). This is because, in the embodiment of FIG. 3, by subdividing each bar-code element 94 in both the X- and Y-directions, correspondingly more edges and/or points are produced compared to subdividing each bar-code element in only one direction (e.g., the X-direction as in FIG. 1).

Providing the bar code 92 with high-scattering regions 94 and low-scattering regions 93 as described above also provides a high-contrast bar-code image 91 (FIG.3) as projected from the reticle 10 to the Substrate 23. This bar-code image 91 is suitable for detection purposes.
It is desirable that the line-width and pitch of the edges and/or points in the high scattering regions 84, 94 be as narrow as possible in each applicable direction, taking into account the resolution limit of the optical system 13 reading the bar code as well as the resolution of the CCD detector used in the optical system.
By configuring and using a bar code such as described in any of the representative embodiments, the contrast between high-scattering portions and low scattering portions of the bar code is substantially enhanced compared to conventional bar codes. As a result, the bar codes are detected more reliably more often, compared to conventional bar codes. This is of substantial benefit during use of microlithography systems utilizing multiple reticles that must be routed into and out of the microlithography system because fewer bar-code-reading errors arise and reticle traffic into and out of the microlithography system can be better controlled. If the edges, points, or other scattering features in each bar-code element are arrayed at a L/S pitch that is below the resolution limit of the optical system 13, then the border-edges of the bar-code elements are not detected, thereby yielding a greater contrast of detected signal from the bar code.

Whereas the invention has been described in connection with representative embodiments, the invention is not limited to those embodiments. On the contrary, the invention is intended to encompass all modifications, alternatives, and equivalents as may be included within the spirit and scope of the invention, as defined by the appended claims.

## Claims

1. A reticle for use in microlithography of a device pattern to an exposure-sensitive substrate using an energy beam, the reticle comprising:
a reticle substrate having a surface;
a device pattern, defined on the reticle substrate, to be transfer-exposed onto the exposure-sensitive substrate; and
a reticle-identification code defined on the surface of the reticle substrate, the reticle-identification code comprising multiple high-scattering regions each exhibiting a relatively high degree of reflection-scattering of irradiated probe light, the high-scattering regions being separated from one another by respective low-scattering regions exhibiting a low degree of reflection-scattering of the irradiated probe light, relative to the high-scattering regions.

2. The reticle of claim 1, wherein:
the low-scattering regions present respective surfaces that are sufficiently smooth to avoid significant reflection-scattering, from the surfaces, of probe light incident on the surfaces; and
each high-scattering region comprises multiple scattering features that reflection-scatter incident probe light.

3. The reticle of claim 2, wherein the surfaces of the low-scattering regions, on which probe light is incident, are coplanar with the surface of the reticle substrate.

4. The reticle of claim 2, wherein the scattering features in each high-scattering region comprise multiple points.

5. The reticle of claim 4, wherein the multiple points are defined by respective pyramidal or conical projections.

6. The reticle of claim 2, wherein the scattering features comprise multiple edges.

7. The reticle of claim 6, wherein the edges in each high-scattering region flank at least one channel extending in the high-scattering region and subdividing the respective high-scattering region.

8. The reticle of claim 7, wherein:
each high-scattering region has multiple respective channels subdividing the high-scattering region; and
the multiple channels extend parallel to each other.

9. The reticle of claim 7, wherein:
each high-scattering region has multiple respective channels subdividing the high-scattering region; and
the multiple channels extend perpendicularly to each other.

10. The reticle of claim 1, wherein the each high-scattering region defines at least three edges that reflection-scatter incident probe light.

11. The reticle of claim 10, wherein the multiple edges in each high-scattering region extend parallel to each other.

12. The reticle of claim 10, wherein the multiple edges in each high-scattering region extend perpendicularly to each other.

13. The reticle of claim 10, wherein the multiple edges in each high-scattering region are defined by multiple respective channels extending in each high-scattering region.

14. The reticle of claim 13, wherein the channels in each high-scattering region extend parallel to each other.

15. The reticle of claim 13, wherein the channels in each high-scattering region extend perpendicularly to each other.

16. The reticle of claim 2, wherein the features in each high-scattering region comprise a line-and-space pattern defining multiple edges.

17. The reticle of claim 16, wherein the line-and-space pattern has a pitch that is below a resolution limit of an optical system used for reading probe light reflected from the identification code.

18. The reticle of claim 2, wherein the features in each high-scattering region comprise a checkerboard pattern of projections and recesses that collectively define multiple edges.

19. The reticle of claim 18, wherein the checkerboard pattern has a pitch that is below a resolution limit of an optical system used for reading probe light reflected from the identification code.

20. A microlithographic exposure apparatus, comprising:
an illumination-optical system situated and configured to illuminate a reticle with a lithographic energy beam, the reticle comprising (i) a reticle substrate having a surface on which is defined a device pattern to be transfer-exposed onto an exposure-sensitive substrate, and (ii) a reticle-identification code defined on the surface of the reticle substrate, the identification code comprising multiple high-scattering regions each exhibiting a relatively high degree of reflection scattering of irradiated probe light, the high-scattering regions being separated from one another by respective low-scattering regions exhibiting a relatively low degree of reflection scattering of the irradiated probe light; and
a probe-light optical system situated relative to the reticle and configured to direct a beam of probe light to the identification code on the reticle and to sense probe light reflected from the identification code so as to provide an identification of the reticle.

21. In a microlithographic method in which a pattern, defined on a reticle, is transfer-exposed from the reticle to an exposure-sensitive lithographic substrate, a method for identifying a reticle, comprising:
providing on the reticle an identification code defined on a surface of the reticle, the identification code comprising multiple high-scattering regions each exhibiting a relatively high degree of reflection scattering of irradiated probe light, the high-scattering regions being separated from one another by respective low-scattering regions exhibiting a relatively low degree of reflection scattering of the irradiated probe light;
irradiating a beam of probe light on the identification code;
sensing probe light reflected from the identification code; and
determining, from the sensed probe light, an identity of the reticle corresponding to the identification code.
